# EUROPEAN PATENT APPLICATION

(11) **EP 2 429 002 A1**
(43) Date of publication of application: **14.03.2012**
(21) Application number: 11180667.5
(22) Date of filing: 09.09.2011
(51) Int. Cl.: H01L 31/052, E04D 13/18, H01L 31/048

(54) **Device provided with solar cells**

(30) Priority: 09.09.2010 NL 2005335
(71) Applicant: Voetdijk, Johannes Wilhelmus Maria, 8111 RM Heeten (NL)
(72) Inventor: Voetdijk, Johannes Wilhelmus Maria, 8111 RM Heeten (NL)
(74) Representative: Jorritsma, Ruurd

(57) **Abstract**

The invention relates to a device (1) provided with solar cells to generate electrical energy. The device comprises a layer with solar cells (2) and an insulation layer (3), wherein one or more ventilation channels (4) are provided between the layer with solar cells (2) and the insulation layer (3). The device further comprises an air cooling system (5) designed to draw in external air, cool the drawn-in external air and feed the cooled air to an inlet (4.1) of the one or more ventilation channels (4). The efficiency of the solar cells can be improved by using a part of the generated electrical energy for the active cooling of the supplied air and therefore the solar cells.

## Description

### TECHNICAL FIELD OF THE INVENTION

The invention relates to a device provided with solar cells. In particular, the invention relates to roof panels provided with solar cells.

### BACKGROUND TO THE INVENTION

It is known that the electrical efficiency of solar cells of the photovoltaic type depends on the temperature of the photovoltaic cell. The efficiency decreases as the temperature of the cell rises. It is therefore also important to keep the temperature of the photovoltaic cell low. However, as the power of the sun increases, the temperature of the cell will increase and the efficiency will thus decrease.

Roof panels provided with solar cells are known from JP2000096794. The roof panel described herein comprises a layer provided with solar cells and an insulation layer with a ventilation layer in between. Ventilation air between the insulation layer and the ventilation layer ensures the cooling of the solar cells, as a result of which the efficiency of the roof panels is increased.

EP0981167 also describes a structure for panels consisting of a layer with solar cells and an insulation layer with ventilation channels in between.

Furthermore, EP2042822 shows a roof construction wherein solar cell modules are placed on roof panels with air channels in between. One or more fans are provided on the upper side of the roof construction to produce an airstream between the solar cell modules and the roof panels in order to lower the temperature of the solar cell modules.

### SUMMARY OF THE INVENTION

The object of the invention is to provide a new device provided with solar cells with an improved electrical efficiency.

According to the invention, this object is achieved with a device which has the characteristics of claim 1. Advantageous embodiments and further designs of the invention can be achieved with the measures specified in the subclaims.

A device provided with solar cells for generating electrical energy according to the invention comprises a layer with solar cells and an insulation layer, wherein one or more ventilation channels are provided between the layer with solar cells and the insulation layer. The device further comprises an air cooling system which is designed to draw in external air, cool the drawn-in external air and feed the cooled air to an inlet of the one or more ventilation channels.

The invention is based on the notion of using a part of the generated energy to cool the solar cells, as a result of which the efficiency of the solar cell is increased. The yield of solar panels (in watt peak) is generally determined at a temperature of 25°C. However, on a warm summer's day with a high light intensity, a solar panel can easily reach a temperature of 65°C; a temperature which produces a yield of some 20% (roughly 0.5% per degree Celsius above the 25°C). In the circumstances in which the temperature of the solar cells is reduced by more than 1°C by the cooled air through the ventilation channels with 0.5% of the generated power, the yield of the device increases. The insulation layer ensures that the generated cooled air substantially absorbs heat from the solar cells.

In one embodiment, the device further comprises one or more sensors to measure at least one of: the light intensity of the light which falls on the layer with sensors and the instantaneous power generated by the layer with solar cells to generate corresponding one or more sensor signals; and a control unit to control the air cooling system depending on the one or more sensor signals. These characteristics make it possible for the efficiency of the device to be further optimised.

In one embodiment, the control unit is designed to activate the air cooling system if the light intensity or generated instantaneous power is higher than a predefined first threshold value, and to de-activate it if the light intensity or generated instantaneous power is lower than a predefined second threshold value. These characteristics offer the advantage that the air cooling system can only be activated if the solar cells deliver sufficient power to control the cooling system. A device is hereby produced which requires no external power supply in order to be able to function.

One embodiment has the characteristic that the device comprises a temperature sensor to measure the temperature of the layer with solar cells, and the control unit is further designed to control the air cooling system depending on the temperature of the layer with solar cells. By measuring the temperature of the solar cells, the temperature sensitivity of the solar cell can be used as a control parameter.

One embodiment has the characteristic that the control unit is designed to activate the air cooling system if the measured temperature of the layer of solar cells is higher than a predefined first temperature value, and to de-activate it if the temperature is lower than a predefined second temperature value. These characteristics provide for a simple control algorithm for the air cooling system.

One embodiment has the characteristic that the control unit is designed to keep the cooling system activated for a predefined minimum on-period following activation before being able to de-activate it. A corresponding embodiment has the characteristic that the control unit is designed to keep the cooling system de-activated for a predefined minimum off-period following de-activation before being able to activate it. The device hereby acquires a quieter behaviour in terms of noise production and energy generation. The temporary decrease in the light intensity due to cloud formation after the air cooling system has been activated does not then result in the air cooling system similarly being activated/de-activated once more.

A different embodiment has the characteristic that the control unit is designed to de-activate the cooling system after a parameter measured by one of the sensors is lower than a predefined first threshold value for a period with a predefined first time duration. A different embodiment has the characteristic that the control unit is designed to activate the cooling system after a parameter measured by one of the sensors is higher than a predefined second threshold value for a period with a predefined second time duration. Unnecessary activation or de-activation of the cooling system is hereby prevented, thereby increasing the average efficiency of the device. The service life of the cooling system is similarly hereby extended.

One embodiment has the characteristic that the cooling system has a variable cooling power, and that the control unit is designed to regulate the cooling power depending on the one or more sensor signals. These characteristics provide the device with facilities for further increasing the efficiency of the device. Thus, the air cooling system can already be activated at lower light intensity, and the cooling power can be made dependent on the light intensity.

One advantageous embodiment has the characteristic that the device comprises panels, wherein each panel comprises a layer with solar cells and an insulation layer with one or more ventilation channels between them in a longitudinal direction, wherein the inlet of the one or more ventilation channels lies on an inlet side, and an outlet of the one or more ventilation channels lies on an outlet side located opposite the inlet side, and the panels with sides which extend between the inlet side and the outlet side lie next to one another.

A further embodiment has the characteristic that the device comprises a channel system located between the cooling system and the inlets of the panels. A plurality of panels can thus be cooled with one cooling system.

One embodiment has the characteristic that, on the inlet side of each panel, the panel comprises an air cooling system. A further embodiment has the characteristic that each panel comprises at least one sensor to generate at least one sensor signal, and a control unit to control the air cooling system depending on the at least one sensor signal. Each panel can hereby be regulated independently.

One advantageous embodiment has the characteristic that the layers and ventilation channels do not lie horizontally, and the inlet is provided on a lowermost-lying side of a ventilation channel. A natural ventilation is hereby produced by the rising of warm air when the air cooling system is de-activated.

A further aspect of the invention entails the provision of a building with a device for generating electrical energy according to one of the aforementioned embodiments. Particularly a barn or stable provided with such a device offers the undertaking great advantages, such as the provision of its own energy requirement and even the supply of energy. In particular, the layer with solar cells and the insulation layer form the roof covering of the building. Additionally or more particularly, the layer with solar cells and the insulation layer form an external wall of the building.

A further aspect of the invention entails the provision of panels which are provided with a layer with solar cells, an insulation layer, an air cooling system and a control unit, wherein ventilation channels are provided between the layer with solar cells and the insulation layer and the air cooling system is designed to cool a stream of air and feed it to the ventilation channels. These panels are very suitable for simply providing a building with a watertight roof covering and/or external walls.

It should be clear that the different aspects specified in this patent application can be combined, and can each be considered separately for a divisional patent application.

### BRIEF DESCRIPTION OF THE FIGURES

These and other aspects, characteristics and advantages of the invention are explained in detail on the basis of the following description with reference to the drawings, wherein the same reference numbers indicate the same or comparable parts, and wherein:
FIG. 1 shows schematically an embodiment of a device according to the invention;
FIG. 2 shows schematically a block diagram of an embodiment of a device according to the invention;
FIG. 3 shows a top view of the embodiment shown in FIG. 1; and
FIG. 4 shows schematically a side view of an embodiment of a roof panel according to the invention.

### DESCRIPTION OF EMBODIMENTS

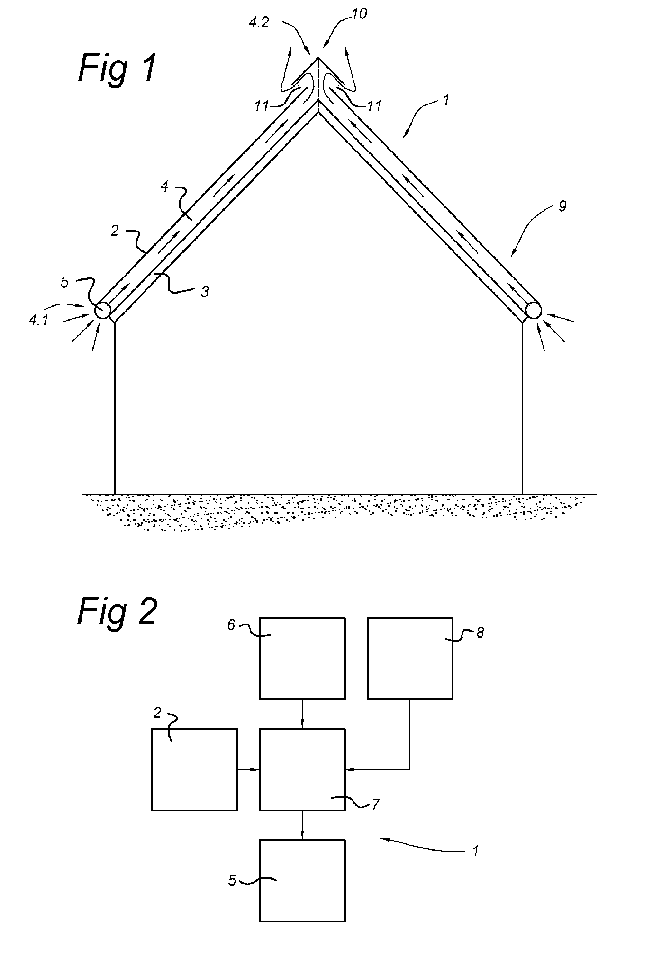

FIG. 1 shows schematically an embodiment of a device 1 according to the invention for generating electrical energy. The device 1 is in the form of a building. The building can be any given building with relatively large roof surface, for example a stable, barn, hangar, gymnasium, apartment block. The roof of the building is formed by a layer with solar cells 2 and an insulation layer 3. The solar cells 2 which are used in the device according to the invention are of the photovoltaic type, which convert light energy into electrical energy. The layer with solar cells can have any suitable profile. Examples of suitable profiles are: sheet piling profile, corrugated sheet profile, slate profile. However, an entirely flat layer with solar cells also suffices. The insulation layer can be made from conventional materials for insulating a roof. In one embodiment, the insulation layer has a thickness of 8 cm. One or more ventilation channels 4 are located between the layer with solar cells and the insulation layer. The ventilation channels are preferably straight and run from an inlet side 4.1 to an opposite-lying outlet side 4.2. Straight ventilation channels are preferred because the air resistance thereof is lower than that of curved ventilation channels. As a result, less energy is required to allow an airstream to flow through the ventilation channels along the layer with solar panels from the inlet to the outlet. The layer with solar cells 2 can be held apart from the insulation layer 4 by spacers (not shown). The spacers may be in the form of joists which extend from the underside of the upper side of the roof. The spacers may be attached directly to the roof construction (not shown) on which the insulation layer is attached. An attachment rail may be fitted on the side of the joists facing away from the insulation layer to attach the layer with solar cells, preferably in the form of photovoltaic solar panels. The attachment rail can also be provided with electrical lines for the electrical connection of the separate solar panels. The joists lie at a distance from one another which corresponds to the length or the width of a solar panel. In this embodiment, the sides of a ventilation channel are formed by the insulation layer, the rear side of one or more solar panels and two sides facing one another of two joists lying next to one another.

It is also possible for the insulation layer to comprise one or more longitudinal slots, which form the ventilation channels. In a different embodiment, the profile of the layer with solar cells provides the ventilation channels, such as, for example, in the case of the sheet piling profile and corrugated sheet profile. In these cases, the layer with solar cells lies partially on the insulation layer with its side facing the insulation layer. The insulation layer ensures, on the one hand, that in summer the heat from the solar cells does not heat up the air in the space of the building. On the other hand, the insulation layer ensures that in winter the heat in the building does not heat up the solar cells. Furthermore, when the air cooling system is in operation, the insulation layer ensures that the cooled air is more or less not heated up by the heat in the building and that the cooled air is heated up almost entirely by drawing heat from the layer with solar cells.

The device further comprises an air cooling system 5. The air cooling system 5 is designed to draw in air, for example by means of a fan, then to cool it and then to discharge cooled air. Air cooling systems are generally known, for example an air conditioning system. The cooled air is then fed to the inlet side 4.1 of the ventilation channels.

The device according to the invention is based on the concept of using a part of the generated energy or generated power to cool the solar cells. The efficiency of the solar cells is increased by lowering the temperature of the solar cells. As soon as the increase in efficiency is greater than the power consumption of the air cooling system, this means that the total efficiency of the device is higher than it would be if no air cooling system were used.

In FIG. 1, the device is integrated into the roof of a building, for example a stable. The airstream is indicated by arrows. The air cooling system 5 draws in ambient air or external air, cools the drawn-in air and feeds this cooled air via the inlet side 4.1 through the one or more ventilation channels 4 between the layer with solar cells 2 and the insulation layer 3.

The ventilation channels 4 extend between the inlet side 4.1 and the outlet side 4.2. The inlet side 4.1 preferably lies lower than the outlet side 4.2. This offers the advantage that a natural airflow occurs in the ventilation channels even when the air cooling system is not in operation. The hot air rises and will ensure that an airstream occurs through the ventilation channels, running from the inlet side to the outlet side. In FIG. 1, the outlet sides 4.2, together with a ridge construction, form an open ridge construction 10, so that the heated air can flow away freely out from the ventilation channels 4. Due to the ridge construction above the outlet sides 4.2, wind can flow freely in an oblique direction in relation to the longitudinal direction of the ridge between the ridge construction and the outlet sides 4.2. This free airstream ensures an additional suction effect, as a result of which additional airflow occurs through the ventilation channels and the electrical efficiency of the device is further increased by, on the one hand, the additional cooling, and, on the other hand, a lower resistance for the fans in the cooling system in order to generate a defined airstream (flow rate) through the ventilation channel.

Protection means 11, for example in the form of a gauze-like material or grilles, can be disposed in the openings between the roof of the ridge construction and the layer with solar cells. As a result, the wind can flow freely between the open ridge construction, whereas birds cannot nest or shelter under the open ridge construction. The gauze-like material also forms a protection against contamination by, for example, leaves. The protection means may be made from any suitable material, such as, for example: fabric, plastic or metal. For example, the gauze-like material is attached in such a way that dirt from outside cannot lie on the material. The side of the gauze-like material facing outwards has an orientation which is directed downwards. It should be clear that the inlet of the cooling system where external air is drawn in is provided with a gauze-like material.

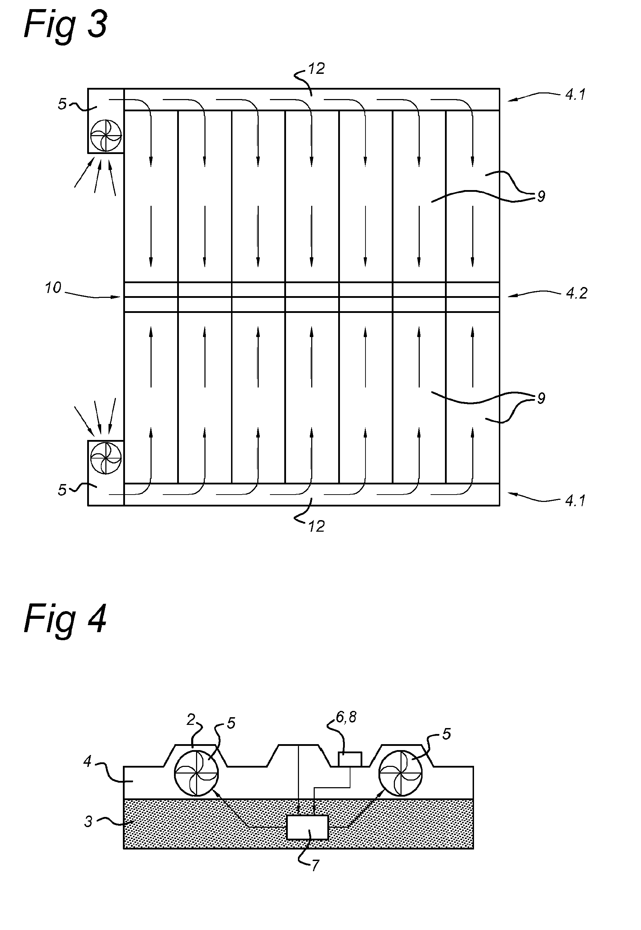

FIG. 3 shows a top view of an embodiment of the device according to the invention. The roof of the building is composed of panels 9 laid next to one another. Each panel 9 comprises a layer with solar cells and an insulation layer with one or more ventilation channels in between. The panels form the roof of the building. On the inlet side 4.1, the ventilation channels are connected to a channel system 12. The channel system 12 connects an outlet of the air cooling system 5 to the inlet sides 4.1 of the ventilation channels and is designed to distribute the cooled air over the panels 9 laid next to one another. The airflow through the device is indicated by arrows. Ambient air is drawn in by the air cooling system 5. The latter feeds the cooled air via the channel system 12 to the panels 9. The cooled air absorbs heat from the solar cells when the air flows through the ventilation channels, and the heated air then leaves the device on the outlet side 4.2 in the open ridge construction 10. The panels 9 have a longitudinal direction and the ventilation channels lie parallel in the longitudinal direction next to one another. FIG. 3 shows two air cooling systems 5, with one cooling system on each gutter side of the roof construction or inlet side 4.1 of the panels. The inlet side 4.1 is positioned on a lowermost-lying part of a panel. It is clear to the person skilled in the art that this can also be one air cooling system or that more than two separate air cooling systems are used. This depends on the cooling capacity of an air cooling system and the total required cooling power.

FIG. 4 shows a side view of a different embodiment of a panel 9. The panel comprises a layer with solar cells 2 in sheet piling profile, an insulation layer 3 and a ventilation channel in between. The side view is from the inlet side. An air cooling system 5 is provided on the inlet side. Cooled air flows through the ventilation channel 4 by means of mechanically driven fans of the air cooling system 5. The air cooling system 5 obtains its energy supplied from the layer with solar cells 2. Each panel has its own control unit 7 which is fed by the layer with solar cells and controls the air cooling system 5. One or more sensors 6, 8 are disposed on the panel to measure, for example, the temperature of the layer with solar cells and the light intensity of the light which falls on the layer with solar cells. In this way, each separate panel forms an embodiment of a device according to the invention. Installation of the device consists in placing the panels on a building as a roof covering or external face of a wall and in connecting the panel to the electrical mains system. The manner in which this is done is known to the person skilled in the art.

FIG. 2 shows a block diagram of the electrical components of a device according to the invention. The device comprises the layer with solar cells 2 which supply their generated energy to a control unit 7. The control unit 7 is designed to form the generated energy in such a way that it is suitable for supplying energy to an air cooling system 5 and the electricity grid (not shown). The device 1 further comprises one or more sensors 6 to measure the light intensity of the sunlight which falls on the solar cells and one or more sensors 8 to measure the temperature of the solar cells on the layer with solar cells 2. The control unit 7 can furthermore be designed to determine the instantaneous power generated by the layer with solar cells. The sensor signals of the sensors 6, 8 and the generated power can be used separately, but also in combination, to control the air cooling system.

In one embodiment, the control unit 7 is designed to activate the air cooling system 7 if the light intensity or generated instantaneous power is higher than a predefined first threshold value, and to de-activate it if the light intensity or generated instantaneous power is lower than a predefined second threshold value. The first and second threshold values correspond to a generated instantaneous power which is higher than the maximum power of the air cooling system 5. Following activation, the device will temporarily be able to deliver less energy to the electricity grid, but the instantaneous generated power will increase as the temperature of the layer with solar cells decreases due to the cooling. The first and second threshold values may have the same values. Different values wherein the first threshold value is greater than the second threshold value ensure a hysteresis effect, as a result of which the air cooling system is activated and de-activated less often.

In a different embodiment, the control unit is designed to keep the cooling system activated for a predefined minimum on-period following activation before being able to de-activate it. Conversely, the control unit is designed to keep the cooling system de-activated for a predefined minimum off-period following de-activation before being able to activate it. The number of activation and de-activation operations is affected by this also.

In one embodiment, the control unit is designed to activate the air cooling system if the measured temperature of the layer of solar cells is higher than a predefined first temperature value, and to de-activate it if the temperature is lower than a predefined second temperature value. The first and second temperature values may have the same values.

The air cooling system 5 is activated and de-activated in the embodiments described above. It is also possible for the device to comprise an air cooling system with a variable cooling power. The control unit 7 is then designed to regulate the cooling power of the air cooling system depending on the one or more sensor signals. Thus, for example, the control unit can be designed to activate the fan(s) of the air cooling system depending on the measured temperature of the solar cells and the measured temperature of the external air with an external air sensor if the temperature difference between the solar cells and the external air is greater than a first predefined temperature difference. As soon as the temperature of the external air rises above a defined value, the cooling power of the air cooling system can be activated and regulated on the basis of the temperature of the layer with solar cells. In this embodiment, the aim is to lower the temperature of the solar cells to a predefined value.

In one embodiment, an external air sensor is used which measures the temperature of the external air, and a sensor which measures the temperature of the air which flows out from the outlet side of the ventilation channels. The measurement signals of these sensors can be used to regulate the cooling power of the air cooling system so that the temperature of the air on the outlet side of the ventilation channels becomes as low as possible, but does not become lower than the external air temperature. In this embodiment, all of the cooling energy of the cooled air is transferred to the layer with solar cells. Along with the cooling power of the air cooling system, it is also possible to regulate the air speed through the ventilation channels. The speed of the fans can thus be dependent on the temperature difference between the external air and the air flowing out from the ventilation channels. As a result, the cooling power of the cooled air is distributed as evenly as possible over the layer with solar cells lying along a ventilation channel.

The layer with solar cells 2 preferably has a colour in places where no solar cells are located, as a result of which the latter absorb as little heat as possible. A light or reflecting surface is preferred.

The measures described above for designing a device according to the invention can obviously be implemented separately or in parallel or in a different combination, or possibly supplemented by further measures, whereby the design will essentially be dependent on the field of application of the device. The invention is not restricted to the embodiments shown. Modifications can be made without departing from the concept of the invention. Thus, for example, the panels can also be made suitable for external walls. The layer with solar cells is then laid on the outside and the insulation layer on the inside. The inlet is provided on the underside and the outlet on the upper side. As an airstream is actively blown through the ventilation channel by the air cooling system, it is also possible to allow the ventilation channels to run horizontally from the inlet to the outlet. The invention can also be used for solar panels which are positioned, for example, on a plot of land. The air cooling system then provides the facility to allow a continuous stream of cooled air to flow along the layer with solar panels. The insulation layer ensures that the layer with solar cells substantially heats up the cooled air.

## Claims

1. Device (1) provided with solar cells for generating electrical energy, comprising a layer with solar cells (2) and an insulation layer (3), wherein one or more ventilation channels (4) are provided between the layer with solar cells (2) and the insulation layer (3), **characterized in that** the device further comprises an air cooling system (5) designed to draw in external air, cool the drawn-in external air and feed the cooled air to the inlet (4.1) of the one or more ventilation channels (4).

2. Device according to Claim 1, **characterized in that** the device further comprises one or more sensors (6) to measure at least one of: the light intensity of the light which falls on the layer with sensors and/or the instantaneous power generated by the layer with solar cells to generate corresponding one or more sensor signals; and a control unit (7) to control the air cooling system depending on the one or more sensor signals.

3. Device according to Claim 2, **characterized in that** the control unit is designed to activate the air cooling system if the light intensity or generated instantaneous power is higher than a predefined first threshold value, and to de-activate it if the light intensity or generated instantaneous power is lower than a predefined second threshold value.

4. Device according to Claim 2 or 3, **characterized in that** the device comprises a temperature sensor (8) to measure the temperature of the layer with solar cells, and the control unit (7) is further designed to control the air cooling system depending on the temperature of the layer with solar cells.

5. Device according to Claim 4, **characterized in that** the control unit is designed to activate the air cooling system if the measured temperature of the layer of solar cells is higher than a predefined first temperature value, and to de-activate it if the temperature is lower than a predefined second temperature value.

6. Device according to Claim 3 or 5, **characterized in that** the control unit is designed to keep the cooling system activated for a predefined minimum on-period following activation before being able to de-activate it.

7. Device according to Claim 3, 5 or 6, **characterized in that** the control unit is designed to keep the cooling system de-activated for a predefined minimum off-period following de-activation before being able to activate it.

8. Device according to any of Claims 2-7, **characterized in that** the cooling system has a variable cooling power, and that the control unit is designed to regulate the cooling power depending on the one or more sensor signals.

9. Device according to any of Claims 2-8, **characterized in that** the cooling system comprises a fan, and that the control unit is designed to regulate the fan depending on the one or more sensor signals.

10. according to any of Claims 8, **characterized in that** the control unit is designed to regulate the fan depending on the difference between a sensor signal which represents the external temperature and a sensor signal which represents the temperature of air which flows out from a ventilation channel.

11. Device according to any of the preceding claims, **characterized in that** the device comprises panels, wherein each panel comprises a layer with solar cells (2) and an insulation layer (3) with one or more ventilation channels (4) between them in a longitudinal direction, wherein the inlet of the one or more ventilation channels lies on an inlet side, and an outlet of the one or more ventilation channels lies on an outlet side located opposite the inlet side, and the panels with sides which extend between the inlet side and the outlet side lie next to one another.

12. Device according to Claim 11, wherein the device comprises a channel system located between the cooling system and the inlets of the panels.

13. Device according to Claim 11, **characterized in that**, on the inlet side of each panel, the panel comprises an air cooling system.

14. Device according to Claim 13, **characterized in that** each panel comprises at least one sensor to generate at least one sensor signal, and a control unit (7) to control the air cooling system depending on the at least one sensor signal.

15. Device according to any of Claims 1-14, **characterized in that** the layers do not lie horizontally, and the inlet (4.1) is provided on a lowermost-lying side of a ventilation channel.
